# EUROPÄISCHE PATENTSCHRIFT

(11) **EP 2 847 464 B1**
(45) Veröffentlichungstag und Bekanntmachung des Hinweises auf die Patenterteilung: **29.11.2017**
(21) Anmeldenummer: 13728153.1
(22) Anmeldetag: 04.06.2013
(51) Int. Cl.: F04B 43/04, F04B 45/047

(54) **VORRICHTUNG UND ANORDNUNG ZUM ERZEUGEN EINES LUFTSTROMS**
DEVICE AND ARRANGEMENT FOR PRODUCTION OF AN AIR FLOW
DISPOSITIF ET ENSEMBLE POUR PRODUCTION D'UN COURANT D'AIR

(30) Priorität: 15.06.2012 DE 102012210127
(43) Veröffentlichungstag der Anmeldung: 18.03.2015
(73) Patentinhaber: Siemens Aktiengesellschaft, 80333 München (DE)
(72) Erfinder: AKIF, Oztzan, 80937 München (DE); VONTZ, Thomas, 81539 München (DE); MOCK, Randolf, 85662 Hohenbrunn (DE)
(86) Internationale Anmeldenummer: PCT/EP2013/061477
(87) Internationale Veröffentlichungsnummer: WO 2013/186084

(56) Entgegenhaltungen:
- WO-A2-00/62589
- DE-A1- 19 539 020
- DE-A1-102008 038 549
- DE-A1-102010 042 599

## Beschreibung

Die vorliegende Erfindung betrifft eine Vorrichtung zum Erzeugen eines Luftstroms insbesondere zur Kühlung elektronischer Bauteile sowie eine Anordnung.

Eine solche Vorrichtung ist beispielsweise aus der DE 10 2008 038 549 A1 bekannt. Die bekannte Vorrichtung umfasst ein Piezoelement und ein Emitterelement. Das Piezoelement regt das Emitterelement zu Schwingungen an, wodurch ein Luftstrom erzeugt wird, welcher elektronische Bauteile kühlt. Diese Art von Vorrichtung weist gegenüber bekannten Kühlvorrichtungen, wie beispielsweise Rotationsventilatoren oder passiven Wärmesenken, den Vorteil auf, dass sie klein baut, leise läuft und darüber hinaus eine hohe Lebensdauer aufweist.

Aufgabe der vorliegenden Erfindung ist es, eine weiter verbesserte Vorrichtung zum Erzeugen eines Luftstroms bereitzustellen, welche sich insbesondere dadurch auszeichnet, dass sie noch kleinere Abmaße aufweist und sich bevorzugt besser in flächige Strukturen, wie beispielsweise Leiterplatten, integrieren lässt.

Zur Lösung dieser Aufgabe wird eine Vorrichtung zum Erzeugen eines Luftstroms insbesondere zur Kühlung elektronischer Bauteile mit einem ringförmigen Piezoelement und einem Emitterelement bereitgestellt. Das Piezoelement ist mittels Anlegens einer Wechselspannung radial in Schwingung versetzbar. Das Emitterelement ist mit dem Piezoelement radial gekoppelt. Die radiale Schwingung des Piezoelements ist dazu eingerichtet, das Emitterelement für das Erzeugen des Luftstroms axial in Schwingung zu versetzen.

Durch die Kombination von radial schwingendem Piezoelement und axial schwingendem Emitterelement kann die Vorrichtung mit sehr kompakten Abmaßen vorgesehen werden. Vor allem kann dadurch erreicht werden, dass sich die Vorrichtung bevorzugt im Wesentlichen nur in einer Ebene, und zwar in der Ebene des ringförmigen Piezoelements, erstreckt.

Die Kopplung zwischen dem Piezoelement und dem Emitterelement ist derart beschaffen, dass sie die radiale Schwingung des Piezoelements auf das Emitterelement überträgt, sodass das Emitterelement in die axiale Schwingung versetzt wird. Beispielsweise ist die Kopplung als in zumindest eine Richtung formschlüssige Verbindung ausgebildet. Alternativ kann auch eine stoff- oder kraftschlüssige Verbindung vorgesehen sein. Das Piezoelement ist mit dem Emitterelement vorzugsweise direkt, d.h. unmittelbar, verbunden.

Das Piezoelement kann beispielsweise als piezoelektrischer Stapel (sog. "Multilayer") oder piezoelektrischer Monolith ausgebildet sein.

"Radial" und "axial" bezieht sich vorliegend auf eine Mittelachse des ringförmigen Piezoelements. Das Piezoelement ist bezüglich der Mittelachse bevorzugt rotationssymmetrisch ausgebildet. Bevorzugt ist das Piezoelement kreisringförmig ausgebildet. Der entsprechende Ring des Piezoelements kann einen rechtecksförmigen Querschnitt aufweisen.

Die Wechselspannung liegt bevorzugt im Bereich der Resonanzfrequenz der Vorrichtung.

Dabei weist das Piezoelement eine axiale Öffnung auf, welche das Emitterelement verschließt. "Verschließen" umfasst hier ein teilweises oder vollständiges Verschließen. Beispielsweise kann im ersteren Fall das Emitterelement ein oder mehrere insbesondere kleine Öffnungen aufweisen, wenn dies zweckdienlich ist. Die axiale Öffnung erlaubt es dem Emitterelement relativ zu dem Piezoelement frei zu schwingen, das heißt, im Bereich der axialen Öffnung besteht keine direkte Verbindung zwischen dem Emitterelement und dem Piezoelement.

Gemäß einer weiteren Ausführungsform weist das Emitterelement einen radialen Abschnitt und einen axialen Abschnitt auf. Während der radiale Abschnitt dazu eingerichtet ist, die axiale Schwingung des Emitterelements auszuführen, so findet über den axialen Abschnitt die Ankopplung des Emitterelements an das Piezoelement statt. Das heißt, insbesondere über den axialen Abschnitt werden die radialen Schwingungen aus dem Piezoelement in das Emitterelement ein- und zu dem radialen Abschnitt hin geleitet, und zwar derart, dass der radiale Abschnitt in axiale Schwingung versetzt wird.

Gemäß einer weiteren Ausführungsform ist der radiale Abschnitt in Form einer Scheibe und/oder der axiale Abschnitt in Form eines Rohrs ausgebildet. Bevorzugt ist die Scheibe kreisförmig ausgebildet. Das Rohr weist bevorzugt einen kreisringförmigen Querschnitt auf.

Gemäß einer weiteren Ausführungsform ist das Emitterelement in die Öffnung zumindest abschnittsweise eingesetzt. Alternativ kann das Piezoelement in das Emitterelement zumindest abschnittsweise eingesetzt sein. Beide vorgenannten Ausführungsformen führen zu weiterer Platzeinsparung.

Gemäß einer weiteren Ausführungsform erstreckt sich der axiale Abschnitt des Emitterelements innerhalb der axialen Öffnung des Piezoelements. Alternativ ist das Piezoelement in dem axialen Abschnitt des Emitterelements angeordnet. Beide Ausführungsformen erlauben eine gute Einkopplung der radialen Schwingung des Piezoelements in das Emitterelement.

Gemäß einer weiteren Ausführungsform schließen der radiale und axiale Abschnitt über einen ersten Radius aneinander an. Dadurch werden Spannungen in dem Emitterelement reduziert, wodurch eine höhere Lebensdauer der Vorrichtung, welche beispielsweise größer 30000 Stunden betragen kann, erzielt wird. Außerdem wird durch den ersten Radius die Steifigkeit des Emitterelements im Bereich der Schwingungsdurchleitung zwischen dem axialen Abschnitt und dem radialen Abschnitt derart beeinflusst, dass sich eine Amplitude im Mittenbereich des radialen Abschnitts in axialer Richtung vergrößern lässt. Diese Vergrößerung der Amplitude erlaubt es, eine stärkere Luftströmung beispielsweise mit einer Geschwindigkeit im Bereich von 0,2 m/s zu erzielen. Die dafür aufzuwendende elektrische Energie ist jedoch vorteilhaft gering.

Gemäß einer weiteren Ausführungsform befindet sich der erste Radius in einem Innen- oder Außenbereich des Emitterelements. Der radiale und axiale Abschnitt des Emitterelements definieren gemeinsam einen Innenbereich, das heißt einen Hohlraum. Entsprechend definieren der radiale und axiale Abschnitt gemeinsam einen in Bezug auf den Innenbereich außen liegenden Außenbereich.

Gemäß einer weiteren Ausführungsform bilden der radiale und axiale Abschnitt im Querschnitt gesehen eine U-Form. In diesem Fall ist es vorzugswürdig, den ersten Radius im Innenbereich des Emitterelements vorzusehen.

Gemäß einer Ausführungsform schließen der axiale und radiale Abschnitt im Querschnitt gesehen T-förmig aneinander an. In diesem Fall ist der erste Radius vorzugsweise im Außenbereich des Emitterelements vorgesehen.

Gemäß einer Ausführungsform stützt sich das Emitterelement über einen radialen Steg axial an dem Piezoelement ab. Auch durch diese Maßnahme kann die Steifigkeit des Emitterelements dahingehend beeinflusst werden, dass eine größere Amplitude im Mittenbereich des radialen Abschnitts erzielt wird.

Gemäß einer weiteren Ausführungsform ist der Steg in einem Außenbereich des Emitterelements angeordnet. Bezüglich des "Außenbereichs" gelten die vorstehenden Ausführungen zu dem Emitterelement.

Vorzugsweise erstreckt sich der Steg nur über einen Teilbereich des Piezoelements in radialer Richtung. Beispielsweise überlappt der Steg in radialer Richtung das Piezoelement um weniger als die Hälfte, vorzugsweise um weniger als ein Drittel, weiter vorzugsweise um weniger als ein Viertel der Ausdehnung des Piezoelements in radialer Richtung.

Gemäß einer weiteren Ausführungsform schließt der Steg über einen zweiten Radius an den radialen Abschnitt des Emitterelements an. Auch durch diese Maßnahme lässt sich die Steifigkeit des Emitterelements dahingehend beeinflussen, dass eine größere Amplitude im Mittenbereich des radialen Abschnitts erzielt wird.

Gemäß einer weiteren Ausführungsform schließt der Steg scharfkantig an den axialen Abschnitt des Emitterelements an. Unter "scharfkantig" ist vorliegend ein Radius kleiner als 0,05 mm, bevorzugt kleiner als 0,02 mm zu verstehen. Auch hierdurch wird die Steifigkeit des Emitterelements im Hinblick auf eine größere Amplitude vorteilhaft beeinflusst.

Gemäß einer weiteren Ausführungsform beträgt eine Resonanzfrequenz der Vorrichtung wenigstens 30 kHz. Bevorzugt beträgt die Resonanzfrequenz größer 100 kHz und weiter bevorzugt größer 1 MHz. Diese hohen Frequenzen lassen sich durch den besonderen Aufbau der Vorrichtung erzielen. Die Vorrichtung ist also bevorzugt dazu vorgesehen, Ultraschall zu erzeugen.

Gemäß einer weiteren Ausführungsform liegt ein Gesamtdurchmesser der Vorrichtung im Bereich zwischen 2 und 100 mm, bevorzugt zwischen 15 und 35 mm. "Gesamtdurchmesser" bezieht sich hier auf die maximale Abmessung der Vorrichtung. Bevorzugt beträgt der erste und/oder zweite Radius 0,05 bis 15 mm, weiter bevorzugt 0,5 bis 3,5 mm. Je nach Resonanzfrequenz und Gesamtdurchmesser der Vorrichtung lassen sich durch derart gewählte erste und zweite Radien große Amplituden bei gleichzeitig langer Lebensdauer und geringem Energieverbrauch der Vorrichtung erzielen.

Gemäß einer weiteren Ausführungsform ist das Emitterelement zumindest teilweise aus Metall oder Kunststoff ausgebildet. Als Kunststoff kommt Plexiglas oder hartes PVC in Betracht. Als Metall eignet sich Aluminium besonders gut. Daneben ist es auch denkbar, Metalle wie Kupfer, Messing, Stahl oder Titan zu verwenden.

Weiterhin wird eine Anordnung mit zumindest einem elektronischen Bauteil und zumindest einer erfindungsgemäßen Vorrichtung bereitgestellt. Die Vorrichtung ist dazu eingerichtet, einen Luftstrom zu erzeugen, der das elektronische Bauteil kühlt.

Beispielsweise kann die Anordnung eine Platine aufweisen, welche das elektronische Bauteil umfasst. Die Vorrichtung kann an der Platine befestigt sein. Darüber hinaus kann die Vorrichtung in die Platine integriert sein. Dabei kann die Haupterstreckungsebene der Vorrichtung parallel zu oder deckungsgleich mit der Haupterstreckungsebene der Platine angeordnet sein. Mit "Haupterstreckungsebene der Vorrichtung" ist die Ebene der Vorrichtung gemeint, in welcher sich das Piezoelement erstreckt.

Vorteilhafte Ausgestaltungen der Erfindung werden nachfolgend unter Bezugnahme auf die beiliegenden Zeichnungen näher erläutert.

Dabei zeigen:
- Fig. 1: in einer perspektivischen Ansicht von schräg oben eine Vorrichtung gemäß einer Ausführungsform;
- Fig. 2: die Vorrichtung aus Fig. 1 von schräg unten gesehen;
- Fig. 3: die Vorrichtung aus Fig. 1 im Schnitt gesehen;
- Fig. 4: die Vorrichtung aus Fig. 1 in einer Draufsicht;
- Fig. 5: in einem Schnitt eine Vorrichtung gemäß einer weiteren Ausführungsform; und
- Fig. 6: eine Anordnung gemäß einer Ausführungsform mit der Vorrichtung aus Fig. 1.

In den Figuren bezeichnen gleiche Bezugszeichen gleiche oder funktionsgleiche Elemente, soweit nichts Gegenteiliges angegeben ist.

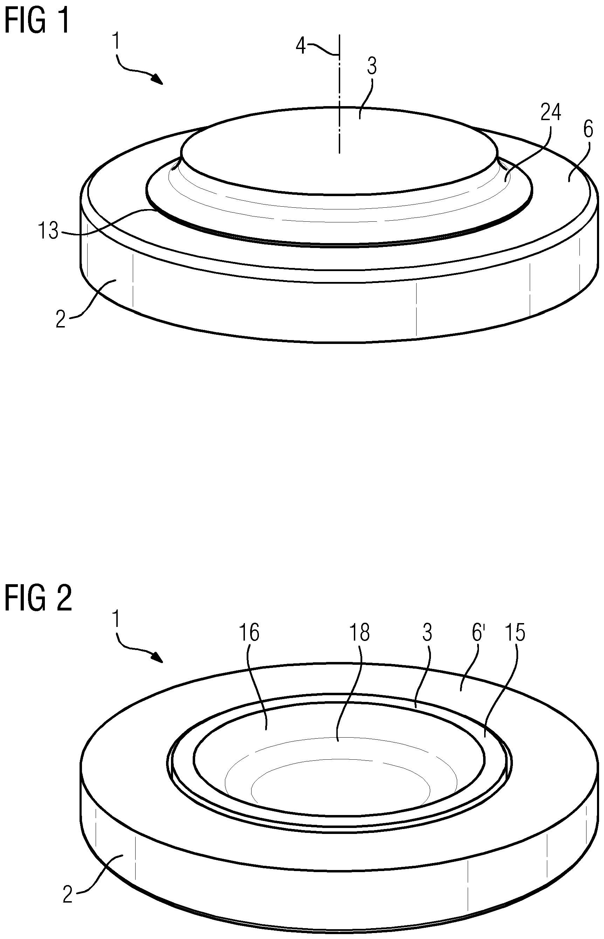

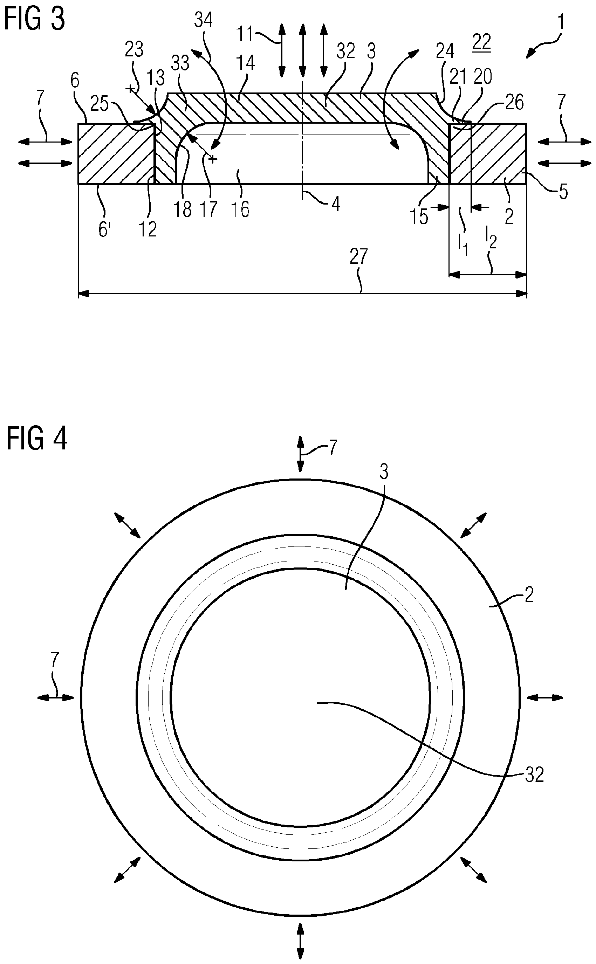

Nachfolgend wird mit Bezugnahme auf die Figuren 1 bis 4 eine Vorrichtung 1 zum Erzeugen eines Luftstroms insbesondere zur Kühlung elektronischer Bauteile näher erläutert. Dabei zeigt Figur 1 eine Ansicht der Vorrichtung 1 von schräg oben, Figur 2 eine Ansicht von schräg unten, Figur 3 eine Schnittansicht und Figur 4 eine Draufsicht.

Die Vorrichtung 1 umfasst ein ringförmiges Piezoelement 2 und ein Emitterelement 3.

Das Piezoelement 2 ist gemäß dem Ausführungsbeispiel kreisringförmig, also rotationssymmetrisch bezüglich einer Mittelachse 4 ausgebildet. Das Piezoelement 2 kann einen rechtecksförmigen Querschnitt 5 aufweisen, wie in Figur 3 zu erkennen. Das Piezoelement 2 ist bevorzugt als piezoelektrischer Stapel ausgebildet. Das Piezoelement 2 kann aus einer Keramik teilweise oder vollständig bestehen. An das Piezoelement 2, insbesondere an axiale, sich gegenüberliegende Stirnflächen 6, 6' (siehe Figuren 1 und 2) kann eine Wechselspannung angelegt werden. "Axial" und "radial" bezieht sich vorliegend auf die Mittelachse 4. Das Anlegen der Wechselspannung führt dazu, dass das Piezoelement 2 radial in Schwingung versetzt wird wie durch entsprechende Pfeile 7 in Figur 3 angedeutet. Die Wechselspannung weist beispielsweise eine Frequenz von 100 kHz auf, welche auch der Resonanzfrequenz der Vorrichtung 1 entspricht.

Das Emitterelement 3 ist mit dem Piezoelement 2 radial gekoppelt. Diese Kopplung erlaubt es, die radiale Schwingung des Piezoelements 2 in das Emitterelement 3 einzukoppeln, was dazu führt, dass das Emitterelement 3 axial (angedeutet durch die Pfeile 11 in Figur 3) in Schwingung versetzt wird. Das axiale Schwingen des Emitterelements 3 erzeugt dann den Luftstrom zum Kühlen der elektronischen Bauteile.

Beispielsweise kann das Emitterelement 3 mit dem Piezoelement 2 radial formschlüssig in zumindest einer Richtung (gemäß einer Ausführungsform jedoch nicht in der Gegenrichtung) verbunden sein. Wie in Figur 3 zu erkennen, ist eine solche formschlüssige Verbindung nach radial innen vorgesehen, das heißt, wenn sich das Piezoelement 2 zusammenzieht, so drückt es von außen gegen das Emitterelement 3, wodurch dieses radial zusammengedrückt wird. Zusätzlich kann das Emitterelement 3 beispielsweise stoffschlüssig mit dem Piezoelement 2 verbunden sein. Ein solcher Stoffschluss zwischen dem Emitterelement 3 und dem Piezoelement 2 kann beispielsweise durch Eingießen des Emitterelements 3 (in dem Fall, dass das Emitterelement 3 aus Metall oder Kunststoff hergestellt ist) in das Piezoelement 2 geschaffen werden. Dabei wirken Adhäsionskräfte dann zwischen dem Piezoelement 2 und dem Emitterelement 3 in radialer Richtung. Alternativ kann ein Hilfswerkstoff, beispielsweise ein Klebstoff, zwischen das Emitterelement 3 und das Piezoelement 2 eingebracht werden, beispielsweise in den mit 12 in Figur 3 bezeichneten Spalt. Der Hilfswerkstoff sorgt dann für die Verbindung in radialer Richtung, in diesem Fall nach radial innen und nach radial außen. Das Emitterelement 3 könnte auch in das Piezoelement 2 eingeklemmt, insbesondere eingeschrumpft, sein.

Das Emitterelement 3 verschließt eine axiale Öffnung 13 des Piezoelements 2 vollständig. Dazu ist das Emitterelement 3 in die Öffnung 13 abschnittsweise eingesetzt. Das Emitterelement 3 weist einen radialen Abschnitt 14 in Form einer kreisförmigen Scheibe und einem axialen Abschnitt 15 in Form eines Rohrs mit kreisringförmigem Querschnitt (siehe Figur 2) auf.

Die beiden Abschnitte 14, 15 sind vorzugsweise einstückig miteinander gebildet. Der radiale Abschnitt 14 erstreckt sich axial vor (bzw. in Figur 3 gesehen oberhalb) dem Piezoelement 2. Der axiale Abschnitt 15 dagegen erstreckt sich innerhalb der axialen Öffnung 13 des Piezoelements 2.

Der radiale und axiale Abschnitt 14, 15 definieren einen Innenbereich 16, also einen Hohlraum (siehe Figuren 2 und 3), gemeinsam. Der radiale und axiale Abschnitt 14, 15 schließen über einen ersten Radius 17 aneinander an, wodurch sich eine Verrundung 18 ergibt. Der erste Radius 17 liegt im Innenbereich 16 des Emitterelements 3.

Das Emitterelement 3 weist weiterhin einen radialen Steg 21 auf. Über den Steg 21 stützt sich das Emitterelement 3 axial an dem Piezoelement 2 ab. Insbesondere liegt der Steg 21 gegen die Stirnseite 6 des Piezoelements 2 an. Wie in Figur 3 zu erkennen, erstreckt sich der Steg 21 radial mit einer Länge 11 über den Querschnitt 5 des Piezoelements 2. Die Länge 11 beträgt dabei nur einen Bruchteil, beispielsweise weniger als ein Drittel, der Gesamtlänge 12 des Querschnitts 5 in radialer Richtung, sodass sich eine kleine Auflagefläche 20 des Stegs 21 auf dem Piezoelement 2 ergibt. Der Steg 21 ist in einem Außenbereich 22 des Emitterelements 3, also außerhalb des Innenbereichs 16 angeordnet. Insbesondere erstreckt sich der Steg 21 radial weg von dem axialen Abschnitt 15. Der Steg 21 schließt über einen zweiten Radius 23 an den radialen Abschnitt 14 des Emitterelements 3 an, wodurch sich eine Verrundung 24 ergibt. Die beiden Radien 17, 23 sind dabei jeweils derart beschaffen, dass sie sich nach innen, also in das Emitterelement 3 hinein, krümmen bzw. konvex beschaffen sind.

Weiterhin sind die Verrundungen 18, 24 vorzugsweise kreisförmig umlaufend (in Bezug auf die Mittelachse 4) beschaffen. Der Steg 21 schließt scharfkantig (eine entsprechende Kante ist mit 25 in Figur 3 bezeichnet) an den axialen Abschnitt 15 an. Der Querschnitt 5 des Piezoelements 2 ist korrespondierend ausgebildet, das heißt, eine entsprechende Kante 26 greift in die entsprechende Aussparung ein.

Gemäß der Ausführungsform beträgt die Resonanzfrequenz der Vorrichtung 1 beispielsweise 100 kHz. Der Gesamtdurchmesser 27 der Vorrichtung beträgt beispielsweise 23 mm. Der erste Radius 17 beträgt beispielsweise 2,0 mm und der zweite Radius 23 beispielsweise 1,4 mm.

Im Betrieb der Vorrichtung 1 bewirken die kleine Auflagefläche 20 des Emitterelements 3 auf dem Piezoelement 2 sowie die Verrundungen 18, 24 am radial äußeren Rand des Emitterelements 3, dass sich eine große Amplitude (angedeutet durch die Pfeile 11) eines Mittenbereichs 32 des radialen Abschnitts 14 des Emitterelements 3 ergibt. Insbesondere wird so ein Durchleitbereich 33 zum Durchleiten der radialen Schwingung 7 hin zu dem Mittenbereich 32 geschaffen, welcher für die große Amplitude bei gleichzeitig langer Lebensdauer und geringem Energiebedarf sorgt. Die entsprechende Verwindung des radialen Abschnitts 14 bezüglich des axialen Abschnitts 15 ist durch Pfeile 34 in Figur 3 angedeutet.
Die Amplitude des Mittenbereichs 32 wiederum führt zu einer Luftströmung mit einer Geschwindigkeit von beispielsweise 0,2 m/s, welche geeignet ist, elektronische Bauteile zu kühlen.

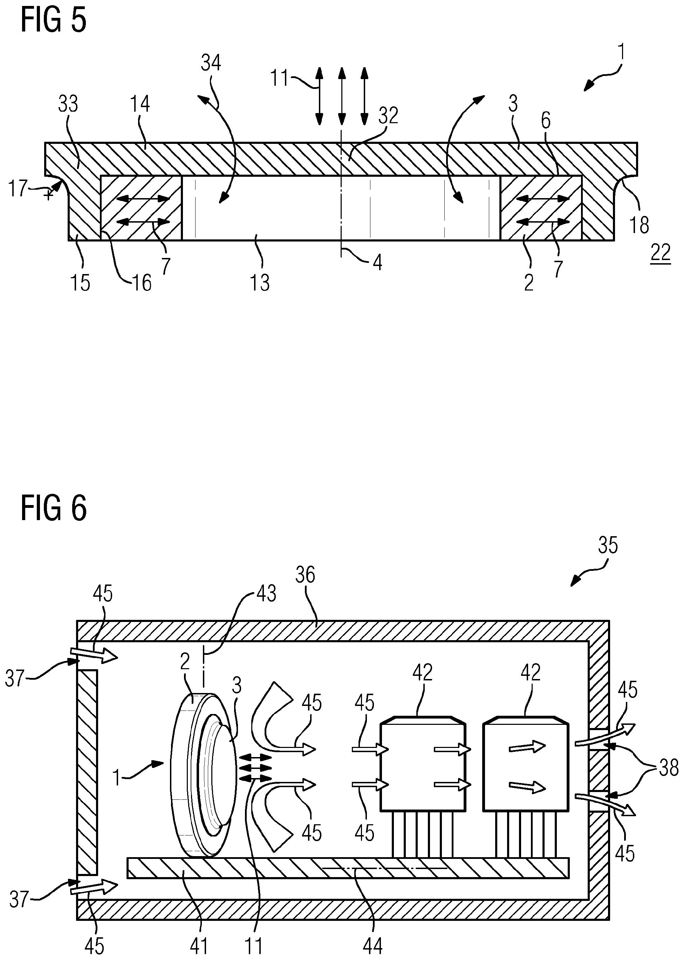

Anhand von Figur 5, welche einen Schnitt ähnlich dem Schnitt aus Figur 3 zeigt, wird eine Vorrichtung 1 gemäß einer weiteren Ausführungsform erläutert.

Das Ausführungsbeispiel gemäß Figur 5 unterscheidet sich von dem gemäß den Figuren 1 bis 4 insbesondere dadurch, dass das Piezoelement 2 in dem durch den radialen Abschnitt 14 und den axialen Abschnitt 15 definierten Innenbereich 16 angeordnet ist. Wenn das Piezoelement 2 radial schwingt (angedeutet durch die Pfeile 7) drückt dieses aufgrund des bestehenden Formschlusses nach radial außen gegen den axialen Abschnitt 15.

Während bei dem Ausführungsbeispiel nach Figur 3 der radiale und axiale Abschnitt 14, 15 des Emitterelements 3 eine U-Form im Querschnitt gesehen bilden, schließen diese bei dem Ausführungsbeispiel nach Figur 5 im Querschnitt gesehen T-förmig aneinander an, so dass der erste Radius 17 bzw. die entsprechende Verrundung 18 in dem Außenbereich 22 liegt. Der radiale Abschnitt 14 des Emitterelements 3 erstreckt sich sowohl über die Öffnung 13 als auch über die Stirnfläche 6 des Piezoelements 2. Insbesondere liegt die Stirnfläche 6 (in Figur 5 gesehen von unten) gegen den radialen Abschnitt 14 im Innenbereich 16 an. Die Ausführungsform nach Figur 5 weist den Vorteil auf, dass thermische Dehnungen des Piezoelements 2 auch über eine lange Betriebsdauer hinweg keine negativen Auswirkungen haben.

Figur 6 zeigt im Schnitt eine Anordnung 35 gemäß einer Ausführungsform.

Die Anordnung 35 umfasst beispielsweise ein Gehäuse 36 mit Lufteintrittsöffnungen 37 und Luftaustrittsöffnungen 38. Im Inneren des Gehäuses 36 ist eine Platine 41 angeordnet, welche mehrere elektronische Bauteile, beispielsweise Leuchtdioden (LEDs) 42, trägt. Weiterhin ist auf der Platine 41 die in den Figuren 1 bis 4 beschriebene Vorrichtung 1 angebracht. Alternativ könnte auch die in Figur 5 beschriebene Vorrichtung 1 vorgesehen sein.

Die Vorrichtung 1 kann sich entweder, wie in Figur 6 dargestellt, mit ihrer Haupterstreckungsebene 43 senkrecht zur Haupterstreckungsebene 44 der Platine 41 erstrecken. Alternativ kann sich die Vorrichtung 1 mit ihrer Haupterstreckungsebene 43 parallel zur Haupterstreckungsebene 44 der Platine 41 erstrecken, wobei die Vorrichtung 1 in die Platine 41 flächig integriert sein kann. Durch die Schwingung des Emitterelements 3 (angedeutet durch die Pfeile 11) entsteht ein Luftstrom 45, so dass durch die Lufteintrittsöffnungen 37 eintretende Luft an den LEDs 42 vorbeigeführt wird und diese dabei kühlt. Hiernach tritt die Luft durch die Luftaustrittsöffnungen 38 aus dem Gehäuse 36 wieder aus.

Obwohl die Erfindung vorliegend anhand von Ausführungsbeispielen beschrieben wurde, ist sie hierauf keineswegs beschränkt, sondern vielfältig modifizierbar.

Beispielsweise kann anstelle der LEDs 42 auch andere Leistungselektronik gekühlt werden.

Die Vorrichtung 1 kann wegen der besonders hohen Schallintensitäten, die durch die Konstruktion erreicht werden, auch als Schallgeber (Sender) im Ultraschallbereich eingesetzt werden.

Die Vorrichtung 1 kann so eingesetzt werden, dass der von dieser erzeugte Schall Grenzschichten um zu kühlende Objekte, insbesondere elektronische Bauteile, aufbricht und so die Kühlung durch verbesserte Konvektion bewerkstelligt wird.

## Patentansprüche

1. Vorrichtung (1) zum Erzeugen eines Luftstroms (45) insbesondere zur Kühlung elektronischer Bauteile (42), mit:
einem ringförmigen Piezoelement (2), welches mittels Anlegens einer Wechselspannung radial in Schwingung (7) versetzbar ist, und
einem Emitterelement (3), welches mit dem Piezoelement (2) radial gekoppelt ist,
wobei die radiale Schwingung (7) des Piezoelements (2) dazu eingerichtet ist, das Emitterelement (3) für das Erzeugen des Luftstroms (45) axial in Schwingung (11) zu versetzen, wobei das Piezoelement (2) eine axiale Öffnung (13) aufweist, welche das Emitterelement (3) verschließt.

2. Vorrichtung nach Anspruch 1, **dadurch gekennzeichnet, dass** das Emitterelement (3) einen radialen Abschnitt (14) und einen axialen Abschnitt (15) aufweist.

3. Vorrichtung nach Anspruch 2, **dadurch gekennzeichnet, dass** der radiale Abschnitt (14) in Form einer Scheibe und/oder der axiale Abschnitt (15) in Form eines Rohrs ausgebildet ist.

4. Vorrichtung nach einem der Ansprüche 1 bis 3, **dadurch gekennzeichnet, dass** das Emitterelement (3) in die Öffnung (13) zumindest abschnittsweise eingesetzt ist oder das Piezoelement (2) in das Emitterelement (3) zumindest abschnittsweise eingesetzt ist.

5. Vorrichtung nach Anspruch 4, **dadurch gekennzeichnet, dass** sich der axiale Abschnitt (15) des Emitterelements (3) innerhalb der Öffnung (13) des Piezoelement (2) erstreckt oder das Piezoelement (2) in dem axialen Abschnitt (15) des Emitterelements (3) angeordnet ist.

6. Vorrichtung nach einem der Ansprüche 2 bis 5, **dadurch gekennzeichnet, dass** der radiale und axiale Abschnitt (14, 15) über einen ersten Radius (17) aneinander anschließen.

7. Vorrichtung nach Anspruch 6, **dadurch gekennzeichnet, dass** sich der erste Radius (17) in einem Innenbereich (16) oder einem Außenbereich (22) des Emitterelements (3) befindet.

8. Vorrichtung nach einem der Ansprüche 1 bis 7, **dadurch gekennzeichnet, dass** sich das Emitterelement (3) über einen radialen Steg (21) axial an dem Piezoelement (2) abstützt.

9. Vorrichtung nach Anspruch 8, **dadurch gekennzeichnet, dass** der Steg (21) in einem Außenbereich (22) des Emitterelements (3) angeordnet ist.

10. Vorrichtung nach Anspruch 8 oder 9, **dadurch gekennzeichnet, dass** der Steg (21) über einen zweiten Radius (23) an den radialen Abschnitt (14) des Emitterelements (3) anschließt.

11. Vorrichtung nach einem der Ansprüche 8 bis 10, **dadurch gekennzeichnet, dass** der Steg (21) scharfkantig an den axialen Abschnitt (15) des Emitterelements (3) anschließt.

12. Vorrichtung nach einem der Ansprüche 1 bis 11, **dadurch gekennzeichnet, dass** eine Resonanzfrequenz derselben wenigstens 30 kHz beträgt, ein Gesamtdurchmesser (27) derselben im Bereich zwischen 2 und 100 mm liegt und/oder der erste und/oder zweite Radius (17, 23) 0,05 bis 15 mm beträgt.

13. Vorrichtung nach einem der Ansprüche 1 bis 12, **dadurch gekennzeichnet, dass** das Emitterelement (3) zumindest teilweise aus Metall oder Kunststoff ausgebildet ist.

14. Anordnung (35) mit:
zumindest einem elektronischen Bauteil (42) und
zumindest einer Vorrichtung (1) nach einem der Ansprüche 1 bis 13, welche dazu eingerichtet ist, einen Luftstrom (45) zu erzeugen, der das wenigstens eine elektronische Bauteil (42) kühlt.

## Claims

1. Device (1) for generating a stream (45) of air, in particular for cooling electronic components (42), having:
an annular piezo element (2) which can be made to undergo radial oscillation (7) by means of applying an alternating voltage, and
an emitter element (3) which is coupled radially to the piezo element (2),
wherein the radial oscillation (7) of the piezo element (2) is configured to make the emitter element (3) undergo axial oscillation (11) for the generation of the stream (45) of air, wherein the piezo element (2) has an axial opening (13) which closes off the emitter element (3).

2. Device according to Claim 1, **characterized in that** the emitter element (3) has a radial section (14) and an axial section (15).

3. Device according to Claim 2, **characterized in that** the radial section (14) is embodied in the form of a disc and/or the axial section (15) is embodied in the form of a pipe.

4. Device according to one of Claims 1 to 3, **characterized in that** the emitter element (3) is inserted at least partially into the opening (13), or the piezo element (2) is inserted at least partially into the emitter element (3) .

5. Device according to Claim 4, **characterized in that** the axial section (15) of the emitter element (3) extends inside the opening (13) of the piezo element (2), or the piezo element (2) is arranged in the axial section (15) of the emitter element (3).

6. Device according to one of Claims 2 to 5, **characterized in that** the radial and axial section (14, 15) connect to one another over a first radius (17).

7. Device according to Claim 6, **characterized in that** the first radius (17) is located in an inner region (16) or an outer region (22) of the emitter element (3).

8. Device according to one of Claims 1 to 7, **characterized in that** the emitter element (3) is supported axially on the piezo element (2) by means of a radial web (21).

9. Device according to Claim 8, **characterized in that** the web (21) is arranged in an outer region (22) of the emitter element (3).

10. Device according to Claim 8 or 9, **characterized in that** the web (21) adjoins the radial section (14) of the emitter element (3) over a second radius (23).

11. Device according to one of Claims 8 to 10, **characterized in that** the web (21) adjoins the axial section (15) of the emitter element (3) in a sharp-edged fashion.

12. Device according to one of Claims 1 to 11, **characterized in that** a resonant frequency thereof is at least 30 kHz, and a total diameter (27) thereof is in the range between 2 and 100 mm, and/or the first and/or second radius (17, 23) is 0.05 to 15 mm.

13. Device according to one of Claims 1 to 12, **characterized in that** the emitter element (3) is constructed at least partially from metal or plastic.

14. Arrangement (35) having:
at least one electronic component (42) and
at least one device (1) according to one of Claims 1 to 13 which is configured to generate a stream (45) of air which cools the at least one electronic component (42).

## Revendications

1. Dispositif (1) destiné à produire un courant d'air (45) en particulier destiné au refroidissement des composants électroniques (42), avec :
un piézo-élément de forme annulaire (2), que l'on peut faire osciller (7) de manière radiale au moyen d'une application d'une tension alternative, et
un élément émetteur (3) qui est couplé de manière radiale avec ledit piézo-élément (2),
dans lequel l'oscillation radiale (7) du piézo-élément (2) est conçue pour faire osciller (11) l'émetteur (3) de manière axiale l'élément en vue de la production du courant d'air (45), dans lequel le piézo-élément (2) présente une ouverture axiale (13) qui enferme l'élément émetteur (3).

2. Dispositif selon la revendication 1, **caractérisé en ce que** l'élément émetteur (3) présente une section radiale (14) et une section axiale (15).

3. Dispositif selon la revendication 2, **caractérisé en ce que** la section radiale (14) est réalisée sous la forme d'un disque et/ou la section axiale (15) est réalisée sous la forme d'un tube.

4. Dispositif selon l'une quelconque des revendications 1 à 3, **caractérisé en ce que** l'élément émetteur (3) est inséré au moins pour ce qui concerne une section dans l'ouverture (13) ou bien le piézo-élément (2) est inséré au moins pour ce qui concerne une section dans l'élément émetteur (3).

5. Dispositif selon la revendication 4, **caractérisé en ce que** la section axiale (15) de l'élément émetteur (3) s'étend à l'intérieur de l'ouverture (13) du piézo-élément (2) ou bien le piézo-élément (2) est agencé dans la section axiale (15) de l'élément émetteur (3).

6. Dispositif selon l'une quelconque des revendications 2 à 5, **caractérisé en ce que** les sections radiale et axiale (14, 15) sont raccordées l'une à l'autre par l'intermédiaire d'un premier rayon (17).

7. Dispositif selon la revendication 6, **caractérisé en ce que** le premier rayon (17) se trouve dans une région intérieure (16) ou une région extérieure (22) de l'élément émetteur (3).

8. Dispositif selon l'une quelconque des revendications 1 à 7, **caractérisé en ce que** l'élément émetteur (3) s'appuie de manière axiale sur le piézo-élément(2) par l'intermédiaire d'une partie saillante radiale (21).

9. Dispositif selon la revendication 8, **caractérisé en ce que** la partie saillante (21) est agencée dans une région extérieure (22) de l'élément émetteur (3).

10. Dispositif selon la revendication 8 ou 9, **caractérisé en ce que** la partie saillante (21) se raccorde à la section radiale (14) de l'élément émetteur (3) par l'intermédiaire d'un deuxième rayon (23).

11. Dispositif selon l'une quelconque des revendications 8 à 10, **caractérisé en ce que** la partie saillante (21) se raccorde de manière acutangulaire à la section axiale (15) de l'élément émetteur (3).

12. Dispositif selon l'une quelconque des revendications 1 à 11, **caractérisé en ce qu'**une fréquence de résonance de celui-ci est d'au moins 30 kHz, un diamètre total (27) de celui-ci se situe dans une plage comprise entre 2 et 100 mm et/ou le(s) premier et/ou deuxième rayon (s) (17, 23) est/sont compris entre 0,05 et 15 mm.

13. Dispositif selon l'une quelconque des revendications 1 à 12, **caractérisé en ce que** l'élément émetteur (3) est réalisé au moins partiellement en métal ou en matière plastique.

14. Agencement (35), comportant :
au moins un composant électronique (42) et
au moins un dispositif (1) selon l'une quelconque des revendications 1 à 13, qui est conçu pour produire un courant d'air (45) qui refroidit le au moins un composant électronique (42) .
